(19) Europäisches Patentamt
European Patent Office
Office européen des brevets

(11) **EP 1 517 368 B1**

(12) **FASCICULE DE BREVET EUROPEEN**

(45) Date de publication et mention de la délivrance du brevet:
**02.11.2011 Bulletin 2011/44**

(51) Int Cl.:
***H01L 23/29*** *(2006.01)* ***H01L 21/20*** *(2006.01)*

(21) Numéro de dépôt: **04104539.4**

(22) Date de dépôt: **20.09.2004**

(54) **Protection de la surface du SiC par une couche de GaN**

Schutz einer SiC-Oberfläche mittels einer GaN-Schicht

Protection of a SiC surface via a GaN-layer

(84) Etats contractants désignés:
**AT BE BG CH CY CZ DE DK EE ES FI FR GB GR HU IE IT LI LU MC NL PL PT RO SE SI SK TR**

(30) Priorité: **22.09.2003 FR 0350585**

(43) Date de publication de la demande:
**23.03.2005 Bulletin 2005/12**

(73) Titulaire: **Commissariat à l'Énergie Atomique et aux Énergies Alternatives 75015 Paris (FR)**

(72) Inventeurs:
• **DAUDIN, Bruno**
  **38700, LA TRONCHE (FR)**
• **BRAULT, Julien**
  **69008, LYON (FR)**

(74) Mandataire: **Poulin, Gérard et al BREVALEX 95 rue d'Amsterdam 75378 Paris Cedex 8 (FR)**

(56) Documents cités:
• **JOHNSON M A L ET AL: "MBE growth and properties of GaN on GaN/SiC substrates" SOLID STATE ELECTRONICS, ELSEVIER SCIENCE PUBLISHERS, BARKING, GB, vol. 41, no. 2, 1 février 1997 (1997-02-01), pages 213-218, XP004033811 ISSN: 0038-1101**
• **K.H. PLOOG, O. BRANDT, R. MURALIDHARAN, A. THAMM, P. WALTEREIT: "Growth of high quality (Al,Ga)N and (Ga,In)N heterostructures on SiC(0001) by both plasma-assisted and reactive molecular beam epitaxy" JOURNAL OF VACUUM SCIENCE AND TECHNOLOGY B, vol. 18, no. 4, juillet 2000 (2000-07), pages 2290-2294, XP002284692**
• **L. X. ZHENG, M.H. XIE, S.Y. TONG: "Adsorption and desorption kinetics of gallium atoms on 6H-SiC(0001) surfaces" PHYSICAL REVIEW B, vol. 61, no. 7, 15 février 2001 (2001-02-15), pages 4890-4893, XP002284693**

## Description

## DOMAINE TECHNIQUE

L'invention concerne un procédé de protection de la surface d'un substrat SiC.

## ETAT DE LA TECHNIQUE ANTERIEURE

Dans le domaine de la microélectronique, on utilise beaucoup de semi-conducteurs de nitrures pour obtenir des transistors, des lasers, des diodes électroluminescentes, des détecteurs dans une gamme de longueurs d'onde allant de l'infra-rouge à l'ultra-violet.

Ces nitrures semi-conducteurs tels que par exemple, GaN, AlN, InN, et leurs alliages ternaires ou quaternaires sont en général réalisés par épitaxie de nitrures sur un substrat support. Les substrats de SiC sont largement utilisés comme support pour la croissance épitaxiale des nitrures semi-conducteurs car ils présentent une structure cristallographique appropriée, un désaccord de maille relativement faible et une bonne conduction thermique, utile dans les applications de puissance.

Quel que soit le mode de croissance épitaxiale choisi, par exemple une épitaxie par jets moléculaires (MBE pour « Molecular Beam Epitaxy » en anglais) ou une épitaxie par décomposition de composés organométalliques (MOCVD pour « MetalOrganic Chemical Vapor Déposition » en anglais), le substrat servant de support doit nécessairement subir une préparation chimique préalablement à son introduction dans la chambre d'épitaxie. Cette préparation chimique consiste généralement en un dégraissage de la surface dudit support, suivi d'une attaque chimique avec différents acides, notamment le HF, pour éliminer l'oxyde natif présent à sa surface.

Cependant, même après avoir subi ce traitement chimique, le substrat de SiC présente encore des traces d'oxyde en surface.

Un procédé pour se débarrasser de ces traces d'oxyde consiste à exposer la surface du substrat SiC à un jet de Gallium à haute température (700-730°C), puis de réitérer cette opération en plaçant le substrat sous vide. En répétant ce cycle un nombre suffisant de fois, on parvient à « nettoyer » la surface du substrat SiC. Le substrat possède alors une structure $\sqrt{3} \times \sqrt{3}$ caractéristique d'une surface SiC propre non oxydée (voir document **[1]**).

Le souhait des fabricants de structures épitaxiées est de réduire au maximum ces étapes nécessaires de préparation du substrat. De là est né l'intérêt pour des substrats dits « épiready », que l'on peut entrer directement dans la chambre d'épitaxie sans préparation préalable. En effet, ces substrats particuliers sont des substrats recouverts d'une couche protectrice dont on se débarrasse in situ, révélant ainsi une surface parfaitement propre pour la croissance épitaxiale.

Le document [2] divulgue que l'exposition d'un substrat SiC de structure {0001} à du Gallium conduit à la formation d'un film continu de Gallium d'une épaisseur d'une monocouche sur le substrat SiC. En exposant un substrat SiC à du Gallium, on peut donc imaginer obtenir une protection de la surface du substrat SiC par une couche de Ga. Par ailleurs, sachant que l'oxyde de Ga se décompose thermiquement aux alentours de 600-650°C, température qui est inférieure à la température de croissance des nitrures, une telle couche de protection peut être évaporée in situ au commencement d'une étape d'épitaxie après que ladite couche ait subi une oxydation volontaire ou accidentelle lors d'un séjour à l'air.

Le problème est que l'oxydation facile du Ga peut également conduire à l'oxydation du SiC.

## EXPOSÉ DE L'INVENTION

Le but de l'invention est de fournir une protection de la surface de substrats SiC qui ne présenterait pas les inconvénients de l'art antérieur. Ce but est atteint par un procédé de protection de la surface d'un substrat de SiC, caractérisé en ce qu'il comprend le dépôt d'une couche temporaire de protection d'une épaisseur au moins égale à deux monocouches sur la surface du substrat à protéger, la couche de protection étant composée de nitrure de gallium. L'épaisseur de la couche temporaire de protection, au moins égale à deux monocouches, correspond environ à 0,5 nm.

On obtient ainsi un procédé de protection d'une surface de substrat SiC qui nous permet d'avoir des substrats SiC « épiready ».

Avantageusement, le dépôt de la couche de protection est réalisé par une épitaxie Stranski-Krastanow, l'épitaxie étant arrêtée avant l'étape d'apparition d'îlots. Rappelons que l'épitaxie Stranski-Krastanow consiste en la croissance de quelques monocouches bidimensionnelles à la surface d'un substrat, suivie d'une croissance tridimensionnelle sous la forme d'îlots à la surface des monocouches créées. Selon l'invention, l'épitaxie Stranski-Krastanow est avantageusement réalisée jusqu'à ce qu'une couche bidimensionnelle de GaN soit formée à la surface du substrat support, la croissance de GaN étant stoppée avant l'apparition d'îlots. On obtient ainsi une couche bidimensionnelle continue, couramment appelée couche de mouillage. Cette couche est avantageusement épaisse de deux monocouches. Ainsi, la seule couche de mouillage forme une protection de la surface de SiC.

Selon une variante, la couche de protection de nitrure de gallium selon l'invention est obtenue par dépôt d'une couche de gallium sur la surface du substrat à protéger, suivi d'une nitruration de la couche de gallium ainsi formée. En effectuant la nitruration d'une couche de Ga déposée à la surface d'un substrat de SiC, on obtient la formation d'une couche continue de GaN, par exemple de deux monocouches d'épaisseur, protégeant la surface du SiC.

Avantageusement, la couche temporaire de protection en nitrure de gallium est éliminée par évaporation sous vide. L'élimination de cette couche de protection sera effectuée lorsqu'on voudra réaliser une épitaxie sur le substrat « épiready ».

L'invention concerne également un substrat « épiready » caractérisé en ce qu'il comporte un substrat de SiC dont au moins une surface est recouverte d'une couche de protection temporaire, ladite couche étant constituée de GaN et ayant une épaisseur de deux monocouches.

Un des avantages de l'invention est qu'en utilisant une couche de protection de GaN, on peut limiter la diffusion de l'oxygène jusqu'au substrat de SiC et ainsi constituer une protection plus efficace qu'avec une couche de Ga, qui s'oxyde plus facilement.

## EXPOSÉ DÉTAILLÉ DE MODES DE RÉALISATION PARTICULIERS

Un substrat « épiready » préparé selon le procédé de l'invention consiste à recouvrir un substrat de SiC de deux monocouches de GaN d'environ 0,5 nm d'épaisseur. Les monocouches sont obtenues selon le mode de croissance Stranski-Krastanow (SK) qui consiste ici en un dépôt d'une couche bidimensionnelle de GaN suivi d'une mise en îlots de GaN. Le dépôt de la couche de protection est réalisé à une température comprise de préférence entre 700 et 800°C dans une enceinte sous vide et est stoppé avant que des îlots n'apparaissent. On obtient alors un substrat SiC « épiready ».

Un substrat de SiC recouvert d'une couche ultramince de GaN suivant le procédé décrit ci-dessus présente les caractéristiques requises pour constituer un substrat « épiready ».

Ensuite, pour pouvoir utiliser ce substrat SiC « épiready » pour réaliser, par exemple, une épitaxie de nitrures, l'utilisateur doit supprimer la couche de protection temporaire. Cette couche de protection temporaire peut éventuellement être évaporée sous vide par l'utilisateur du substrat après que la couche de protection ait été oxydée. En effet, comme l'oxyde de Ga (de même que l'oxyde de GaN) se décompose thermiquement aux alentours de 600-650°C et que cette température est inférieure à la température d'épitaxie nécessaire à la croissance épitaxiale de nitrures semi-conducteurs sur un substrat de SiC, l'épitaxie s'effectuera sur un substrat débarrassé de sa couche de protection. Par ailleurs, le procédé selon l'invention n'entraîne pas de pollution au niveau de la croissance des nitrures puisque la couche protectrice est constituée des matériaux eux-mêmes utilisés lors de l'épitaxie de nitrures sur SiC.

## BIBLIOGRAPHIE

[1] K. H. PLOOG et al., J. Vac. Sci. Technol., B18 (4), page 2290, (2000).
[2] L. X. Zheng et al., Phys. Rev., B61, page 4890, (2001).

## Revendications

1. Procédé de protection de la surface d'un substrat de SiC, **caractérisé en ce qu'**il comprend le dépôt d'une couche temporaire de protection d'une épaisseur au moins égale à deux monocouches sur la surface du substrat à protéger, la couche de protection étant composée de nitrure de gallium.

2. Procédé de protection selon la revendication précédente, **caractérisé en ce que** le dépôt de la couche de protection est réalisé par une épitaxie Stranski-Krastanow, l'épitaxie étant arrêtée avant l'étape d'apparition d'îlots.

3. Procédé de protection selon la revendication 1, **caractérisé en ce que** la couche de protection de nitrure de gallium est obtenue par dépôt de gallium sur la surface du substrat puis par nitruration de la couche de gallium formée.

4. Procédé de protection selon l'une quelconque des revendications 2 ou 3, **caractérisé en ce que** la couche temporaire de protection en nitrure de gallium est éliminée par évaporation sous vide.

5. Substrat « épiready », **caractérisé en ce qu'**il comporte un substrat de SiC dont au moins une surface est recouverte d'une couche de protection temporaire, ladite couche étant constituée de GaN et ayant une épaisseur de deux monocouches.

## Claims

1. Process for protecting the surface of an Sic substrate, **characterised in that** it comprises deposition of a temporary protection layer with a thickness equal to at least two monolayers on the surface of the substrate to be protected, the protection layer being composed of gallium nitride.

2. Protection process according to the previous claim, **characterised in that** the deposition of the protection layer is made by a Stranski-Krastanow epitaxy, the epitaxy being stopped before the appearance of islands.

3. Protection process according to claim 1, **characterised in that** the protection layer of gallium nitride is obtained by depositing gallium on the surface of the substrate, followed by nitridation of the gallium layer formed.

4. Protection process according to any one of claims 2 or 3, **characterised in that** the temporary protection layer made of gallium nitride is eliminated by vacuum evaporation.

5. "Epiready" substrate, **characterised in that** it comprises an SiC substrate for which at least one surface is covered by a temporary protection layer, the said layer being composed of GaN and being two monolayers thick.


**Patentansprüche**

1. Verfahren zum Schutz der Fläche eines SiC-Substrats, **dadurch gekennzeichnet, dass** es das Auftragen einer vorübergehenden Schutzschicht mit einer Dikke, die mindestens gleich zwei Monoschichten ist, auf der Fläche des zu schützenden Substrats umfasst, wobei die Schutzschicht aus Galliumnitrid hergestellt ist.

2. Schutzverfahren nach dem vorhergehenden Anspruch, **dadurch gekennzeichnet, dass** das Auftragen der Schutzschicht durch Stranski-Krastanow-Epitaxie ausgeführt wird, wobei die Epitaxie vor dem Schritt des Auftretens von Inseln angehalten wird.

3. Schutzverfahren nach Anspruch 1, **dadurch gekennzeichnet, dass** die Schutzschicht aus Galliumnitrid durch Auftragen von Gallium auf der Fläche des Substrats und dann durch Nitrieren der gebildeten Galliumschicht erhalten wird.

4. Schutzverfahren nach einem der Ansprüche 2 oder 3, **dadurch gekennzeichnet, dass** die vorübergehende Schutzschicht aus Galliumnitrid durch Vakuumverdampfung beseitigt wird.

5. "Epi-Ready-Substrat", **dadurch gekennzeichnet, dass** es ein SiC-Substrat umfasst, von dem mindestens eine Fläche durch eine vorübergehende Schutzschicht bedeckt ist, wobei die Schicht aus GaN gebildet ist und eine Dicke von zwei Monoschichten aufweist.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **K. H. PLOOG et al.** *J. Vac. Sci. Technol.,* 2000, vol. B18 (4), 2290

- **L. X. Zheng ; 2001 et al.** *Phys. Rev., B,* vol. 61, 4890